# EUROPEAN PATENT APPLICATION

(11) **EP 4 665 094 A1**
(43) Date of publication of application: **17.12.2025**
(21) Application number: 25177722.3
(22) Date of filing: 20.05.2025
(51) Int. Cl.: H05K 7/14, H05K 7/20, H01G 2/04, H01G 2/08, H01G 4/32, H02M 7/00

(54) **SYSTEMS FOR CAPACITOR FOR INVERTER FOR ELECTRIC VEHICLE**

(30) Priority: 12.06.2024 US 202463658919 P; 07.02.2025 US 202519048073
(71) Applicant: BorgWarner US Technologies LLC, Wilmington, DE 19801 (US)
(72) Inventor: BOYD, Douglas, Carol Stream, IL (US); EBENHART, Mark Alan, Kokomo, IN (US); CHANG, Hung-Li, Carmel, IN (US)
(74) Representative: Office Freylinger

(57) **Abstract**

A system including an inverter to convert direct current (DC) power from a battery to alternating current (AC) power to drive a motor, wherein the inverter includes: a capacitor assembly, the capacitor assembly including: a planar busbar including a first DC busbar and a second DC busbar; a capacitor on a same side of the first DC busbar and the second DC busbar, the capacitor including a first end cap extending in a direction substantially perpendicular to a longitudinal direction of the planar busbar; and a first connection plate shaped to transfer heat from the first end cap of the capacitor and the first connection plate to a first external surface.

## Description

### CROSS-REFERENCE TO RELATED APPLICATION(S)

This application claims the benefit of priority to U.S. Provisional Patent Application No. 63/658,919, filed June 12, 2024, the entirety of which is incorporated by reference herein.

### TECHNICAL FIELD

Various embodiments of the present disclosure relate generally to a capacitor, and, more particularly, to systems for thermal management of a capacitor for an inverter for an electric vehicle.

### INTRODUCTION

Thermal management is considered a key technical aspect in an electric vehicle system. A cooling module of an inverter system controls the performance and efficiency of an overall driving system of an electric vehicle. However, some cooling modules may have limited capability for thermal management.

The present disclosure is directed to overcoming one or more of these above-referenced challenges.

### SUMMARY OF THE DISCLOSURE

In some aspects, the techniques described herein relate to a system including an inverter to convert direct current (DC) power from a battery to alternating current (AC) power to drive a motor, wherein the inverter includes: a capacitor assembly, the capacitor assembly including: a planar busbar including a first DC busbar and a second DC busbar; a capacitor on a same side of the first DC busbar and the second DC busbar, the capacitor including a first end cap extending in a direction substantially perpendicular to a longitudinal direction of the planar busbar; and a first connection plate shaped to transfer heat from the first end cap of the capacitor and the first connection plate to a first external surface.

In some aspects, the techniques described herein relate to a system, wherein the first connection plate extends beyond electrical connections to the first end cap.

In some aspects, the techniques described herein relate to a system, wherein the first connection plate includes: a first portion at the first end cap; and a second portion extending substantially perpendicular from the first portion, wherein the capacitor is between the planar busbar and the second portion of the first connection plate.

In some aspects, the techniques described herein relate to a system, wherein the first connection plate includes: a first portion at the first end cap; and a second portion extending substantially perpendicular from the first portion, wherein the second portion of the first connection plate is between the capacitor and the planar busbar.

In some aspects, the techniques described herein relate to a system, wherein the first connection plate further includes: a first portion at the first end cap; a second portion extending substantially perpendicular from the first portion; and a third portion extending substantially perpendicular from the first portion, wherein the capacitor is between the second portion and the third portion.

In some aspects, the techniques described herein relate to a system, wherein the first connection plate includes copper.

In some aspects, the techniques described herein relate to a system, wherein the capacitor further includes: a second end cap extending in the direction substantially perpendicular to the longitudinal direction of the planar busbar, the second end cap on an end of the capacitor that is opposite to that of the first end cap.

In some aspects, the techniques described herein relate to a system, wherein the system further includes: a second connection plate provided at the second end cap to connect the capacitor to the second DC busbar, wherein the second connection plate is shaped to transfer heat from the second end cap of the capacitor and the second connection plate to a second external surface.

In some aspects, the techniques described herein relate to a system, further including: the battery configured to supply the DC power to the inverter; and the motor configured to receive the AC power from the inverter to drive the motor, wherein the system is provided as a vehicle.

In some aspects, the techniques described herein relate to a system, wherein the first connection plate includes four connection points that couple the first connection plate to the first end cap.

In some aspects, the techniques described herein relate to a system, wherein the first connection plate includes a first tab and a second tab, wherein the first tab and the second tab both connect to the first DC busbar.

In some aspects, the techniques described herein relate to a capacitor assembly including: a capacitor including a wound metalized polypropylene film including a central axis, a first end cap on a first end of the wound metalized polypropylene film, and a second end cap on a second end, opposite to the first end, of the wound metalized polypropylene film; a first connection plate on the first end cap, wherein the first connection plate is oversized for a rated current to thereby transfer heat away from the capacitor; and a second connection plate on the second end cap, wherein the second connection plate is oversized for the rated current to thereby transfer heat away from the capacitor.

In some aspects, the techniques described herein relate to a capacitor assembly, wherein the first connection plate includes: a first portion at the first end cap; and a second portion extending substantially perpendicular from the first portion and contacting the capacitor.

In some aspects, the techniques described herein relate to a capacitor assembly, wherein the capacitor includes a first surface and a second surface opposite to the first surface, wherein the first surface of the capacitor connects the first end cap to the second end cap, and the second surface of the capacitor connects the first end cap to the second end cap.

In some aspects, the techniques described herein relate to a capacitor assembly, wherein the first connection plate includes: a first portion at the first end cap; and a second portion extending substantially perpendicular from the first portion, the second portion contacting the first surface or the second surface of the capacitor.

In some aspects, the techniques described herein relate to a capacitor assembly, wherein the first connection plate includes: a first portion at the first end cap; a second portion extending substantially perpendicular from the first portion and contacting the first surface of the capacitor; and a third portion extending substantially perpendicular from the first portion and contacting the second surface of the capacitor.

In some aspects, the techniques described herein relate to a capacitor assembly for a power converter chassis pocket, the capacitor assembly including: a planar busbar including a first DC busbar and a second DC busbar; a capacitor on a same side of the first DC busbar and the second DC busbar, the capacitor including: a metalized polypropylene film wound around a central axis extending in a direction substantially parallel with a longitudinal direction of the planar busbar, a first end cap on a first end of the metalized polypropylene film, and a second end cap on a second end of the metalized polypropylene film opposite from the first end; a first connection plate provided at the first end cap to connect the capacitor to the first DC busbar; and a second connection plate provided at the second end cap to connect the capacitor to the second DC busbar, wherein the first connection plate and the second connection plate are shaped to transfer heat from the first end cap and the second end cap to the power converter chassis pocket.

In some aspects, the techniques described herein relate to a capacitor assembly, wherein the first connection plate extends along an entire length of the first end cap.

In some aspects, the techniques described herein relate to a capacitor assembly, wherein the first connection plate is coupled to the first end cap by mechanical stamping.

In some aspects, the techniques described herein relate to a capacitor assembly, wherein a portion of the first connection plate is located between the capacitor and the planar busbar.

In some aspects, the techniques described herein relate to a system including an inverter to convert direct current (DC) power from a battery to alternating current (AC) power to drive a motor, wherein the inverter includes: a capacitor assembly, the capacitor assembly including: a planar busbar including a first DC busbar and a second DC busbar; a capacitor on a same side of the first DC busbar and the second DC busbar, the capacitor including a first end cap extending in a direction substantially perpendicular to a longitudinal direction of the planar busbar; and a first connection plate provided at the first end cap to connect the capacitor to the first DC busbar.

In some aspects, the techniques described herein relate to a system, wherein the inverter further includes: a thin wall insulator provided at the first end cap.

In some aspects, the techniques described herein relate to a system, wherein the capacitor includes a second end cap extending in a direction substantially perpendicular to the longitudinal direction of the planar busbar on an opposite end of the capacitor from the first end cap.

In some aspects, the techniques described herein relate to a system, further including: a second connection plate connecting the second end cap to the second DC busbar.

In some aspects, the techniques described herein relate to a system, wherein the planar busbar further includes an insulation layer between the first DC busbar and the second DC busbar.

In some aspects, the techniques described herein relate to a system, wherein the first connection plate includes a first tab and a second tab, wherein the first tab and the second tab both connect to the first DC busbar.

In some aspects, the techniques described herein relate to a system, wherein the first connection plate includes copper.

In some aspects, the techniques described herein relate to a system, wherein the first connection plate extends through an opening in the second DC busbar.

In some aspects, the techniques described herein relate to a system, further including: a second capacitor on the same side of the first DC busbar and the second DC busbar, the second capacitor including a first end cap extending in a direction substantially perpendicular to the longitudinal direction of the planar busbar; and a second connection plate provided at the first end cap of the second capacitor to connect the second capacitor to the first DC busbar, wherein the second connection plate and connection plate align and both extend substantially perpendicular to each other.

In some aspects, the techniques described herein relate to a system, further including: the battery configured to supply the DC power to the inverter; and the motor configured to receive the AC power from the inverter to drive the motor, wherein the system is provided as a vehicle.

In some aspects, the techniques described herein relate to a capacitor assembly including: a capacitor including a wound metalized polypropylene film including a central axis, a first end cap on a first end of the wound metalized polypropylene film, and a second end cap on a second end, opposite to the first end, of the wound metalized polypropylene film; a first connection plate connected to the first end cap and extending substantially perpendicular from the central axis in a first direction; and a second connection plate connected to the second end cap and extending substantially perpendicular from the central axis in the first direction.

In some aspects, the techniques described herein relate to a capacitor assembly, wherein the first connection plate includes a first tab and a second tab, the first tab and the second tab extending substantially perpendicular from the central axis in the first direction.

In some aspects, the techniques described herein relate to a capacitor assembly, wherein the second connection plate includes a first tab and a second tab, the first tab and the second tab extending substantially perpendicular from the central axis in the first direction.

In some aspects, the techniques described herein relate to a capacitor assembly, wherein the first connection plate is coupled to the first end cap by a press fitting.

In some aspects, the techniques described herein relate to a capacitor assembly, wherein the first end cap is arc sprayed zinc.

In some aspects, the techniques described herein relate to a capacitor assembly for a power converter chassis pocket, the capacitor assembly including: a planar busbar including a first DC busbar and a second DC busbar; a capacitor on a same side of the first DC busbar and the second DC busbar, the capacitor including: a metalized polypropylene film wound around a central axis extending in a direction substantially parallel with a longitudinal direction of the planar busbar, a first end cap on a first end of the metalized polypropylene film, and a second end cap on a second end of the metalized polypropylene film opposite from the first end; a first connection plate provided at the first end cap to connect the capacitor to the first DC busbar; and a second connection plate provided at the second end cap to connect the capacitor to the second DC busbar.

In some aspects, the techniques described herein relate to a capacitor assembly, wherein the first connection plate and the second connection plate are configured to transfer heat from the first end cap and the second end cap to the power converter chassis pocket.

In some aspects, the techniques described herein relate to a capacitor assembly, wherein the first DC busbar includes an opening, and the second connection plate extends through the opening in the first DC busbar to connect to the second DC busbar.

In some aspects, the techniques described herein relate to a capacitor assembly, further including: a thin wall insulator provided at the first end cap; and an epoxy layer between the thin wall insulator and the first end cap.

In some aspects, the techniques described herein relate to a capacitor assembly, wherein: the thin wall insulator is a plastic material for high voltage insulation, and the epoxy layer is configured to seal the capacitor assembly for environmental protection.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including an inverter, according to one or more embodiments.
FIG. 2 depicts an electrical power schematic of a three phase inverter module, according to one or more embodiments.
FIG. 3 depicts an exploded view of an exemplary capacitor, according to one or more embodiments.
FIG. 4 depicts an exemplary capacitor without epoxy, according to one or more embodiments.
FIG. 5 depicts an exemplary capacitor with epoxy, according to one or more embodiments.
FIG. 6 depicts a cross section view of an exemplary capacitor, according to one or more embodiments.
FIG. 7 depicts a cross section of an inverter, according to one or more embodiments.
FIG. 8 depicts a detailed cross section of an inverter, according to one or more embodiments.
FIG. 9 depicts side views and a front view of a capacitor assembly, according to one or more embodiments.
FIG. 10A depicts a front view of a capacitor assembly with an L-shaped connection plate, according to one or more embodiments.
FIG. 10B depicts a side view of a capacitor assembly with an L-shaped connection plate, according to one or more embodiments.
FIG. 11A depicts a front view of a capacitor assembly with a T-shaped connection plate, according to one or more embodiments.
FIG. 11B depicts a side view of a capacitor assembly with a T-shaped connection plate, according to one or more embodiments.
FIG. 12A depicts a front view of a capacitor assembly with a C-shaped connection plate, according to one or more embodiments.
FIG. 12B depicts a side view of a capacitor assembly with a C-shaped connection plate, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, the switching devices may be described as switches or devices, but may refer to any device for controlling the flow of power in an electrical circuit. For example, switches may be metal-oxide-semiconductor field-effect transistors (MOSFETs), bipolar junction transistors (BJTs), insulated-gate bipolar transistors (IGBTs), or relays, for example, or any combination thereof, but are not limited thereto.

Various embodiments of the present disclosure relate generally to a capacitor, and, more particularly, to systems for thermal management of a capacitor for an inverter for an electric vehicle

Inverters, such as those used to drive a motor in an electric vehicle, for example, are responsible for converting High Voltage Direct Current ("HVDC") into Alternating Current ("AC") to drive a motor. Inverters may include a power module and corresponding cooling modules assemblies configured to cool the power modules. Power modules may include one or more silicon carbide ("SiC")-based power switches that deliver relatively high power densities and efficiencies needed to extent battery range and performance. The power module may contain circuitry and components that are configured to convert DC current from the electric vehicle battery to AC current, which can be utilized within the electric motor that drives the propulsion system. The heat sink (e.g., the chassis of the inverter) may receive heat generated during operation of the capacitor, which may cool the capacitor. The laminated HVDC +/- bus bar plates with an internal insulator may lower an equivalent series inductance ("ESL") between a battery and motor of the electric vehicle.

Inverter systems may have high ambient temperature during operation. The performance, assembly process and time, and reliability of the power modules of an inverter system may be dependent on a built-in coolant structure. The heat sink of the inverter systems may improve performance and reliability.

Electric vehicles ("EVs") and hybrid electric vehicles ("HEVs") may include an inverter with a capacitor (e.g., DC bulk capacitor) to provide filtering (or adequate filtering) of electrical noise. Power of an inverter used to drive electric motors (e.g., e-motors) may produce significant heat in the DC bulk capacitor, which may be managed to prevent (or reduce) thermal overload and permanent damage (or damage) to the DC bulk capacitor. In some systems, internal construction of DC bulk capacitors may include connections of wound capacitive elements to electrical circuits. Some systems may include cooling of main electrode plate(s) that may be attached to capacitive elements. Some systems may provide a cooling surface with a DC bulk capacitor placed in a vertical stack-up with cooling channels.

In electric vehicle technologies, vehicle range is a key measurable and market driver for new EVs and depends on efficiency of the overall system of the EV. Some systems for EVs may place metallized polypropylene capacitive elements (e.g., having a 105°C maximum operating temperature) between high voltage (HV) and/or high current electrode plates (HV+/HV-), which may limit the lowest Equivalent Series Inductance (ESL) and high current capability of the system. This design (e.g., "the sandwich design" or "the sandwich structure") of DC link bulk capacitors may also drive oversizing of expensive power components to protect against thermal overload of the capacitor, which may add unnecessary mass and/or cost, and may reduce vehicle efficiency.

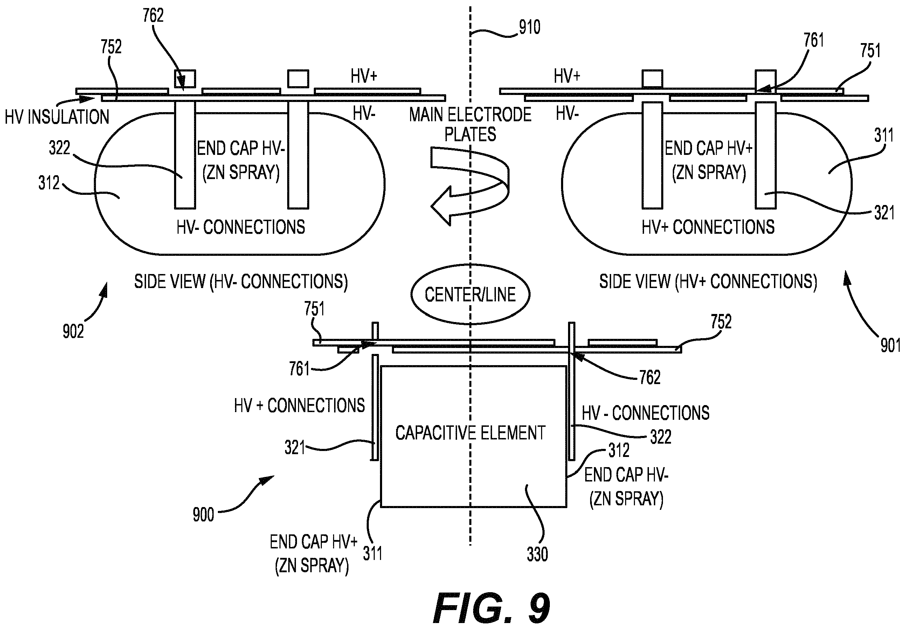

The stacked bus bar design may have advantages of low ESL and high DC capacity compared to some designs (e.g., "the sandwich design").The stacked bus bar design depicted in FIG. 9, for example, may include placing the end caps of the capacitive elements (e.g., with the one or more HV- end caps and the one or more HV+ end caps) at ninety degrees (90°) from a plane of the electrode plate bus bars. The stacked bus bar design may include electrical connections from the HV+ and HV- electrode plates to the end caps of the capacitive elements (e.g., the one or more HV- end caps and the one or more HV+ end caps). However, the stacked bus bar design may cause the heat from DC current flowing through the electrode plates to add to the heat from AC current flowing within the elements without an efficient path for thermal transfer of the heat from the capacitive elements.

In some systems, bulk capacitors may include basic electrical connections to elements (e.g., for soldering), but do not utilize the metal surface area created by the arc sprayed zinc end caps of the capacitive elements or the electrical connection terminals on the sides for thermal transfer along the more thermally efficient axis.

Some systems may face a problem of thermal overload to capacitive elements due to hot spots within capacitive cells connected above and/or below the electrode plates. This challenge may be addressed (or solved) by modifying the package of the capacitive cells to maximize (or improve) the thermal transfer from the center of the element out though the surfaces of end caps and connection plates to utilize the improved (or much better) thermal conductivity. Accordingly, in one or more embodiments, a design for capacitive elements uses (or is configured to use) the surfaces of the arc sprayed zinc end caps of each capacitive element and connection plates to improve heat flow from the side end caps of each cell.

In some systems, a capacitor element may include capacitors that are sold commercially as finished parts, which include packages that are deliberately designed for mechanical structure and include thicker wall plastic housings and basic electrical connections. Such designs do not take advantage of the required metal surface areas (e.g., zinc end cap and connection plate) to intentionally transfer heat through the most effective axis.

In some systems, an alternating current (e.g., AC current) created during the switching of power devices produces heat within capacitive elements. The AC current flows in the metallized patterns of the capacitive elements and produces heat within the capacitive element. Due to thermal transfer, the hottest spot from the AC current is in the center of the capacitive element. Additionally or alternatively, the capacitive elements are heated by a direct current (e.g. DC current), which flows through the electrode plates adjacent to the capacitive elements. The heat within the capacitive element (from the AC current) and next to the capacitive element (from the DC current) may be additive and both contribute to the hot spots created in the capacitive element in the assembly.

The presence of hot spots within the capacitive elements may degrade their lifetime and reliability. Redistribution of heat to reduce hot spots may prevent (or reduce) oversizing of components to provide protection (or adequate protection) from thermal overload. Some systems may include commercially available capacitors that include basic electrical connections to capacitive elements (e.g., for soldering), but do not use the shape of the required electrical connection terminals connected to the arc sprayed end caps of the capacitor for thermal distribution and transfer to reduce hot spots.

Some systems may face a problem of thermal overload to capacitive elements due to hot spots within capacitive cells connected above and/or below the electrode plates. This challenge may be addressed (or solved) by modifying the shape of the electrical connection terminals to maximize (or improve) the thermal transfer from the center of the element out through the surfaces of end caps and connection plates.

For an increased system efficiency to cost, the HV+/HV- electrode plates may be located on top (or directly on top) of one another (separated by HV insulation). This arrangement may require the capacitive elements to be located either above or below the pair of electrode plates. To obtain the lowest overall profile inverter to allow packaging in more vehicle applications, the capacitive elements may be oriented ninety degrees (90°) (e.g., end caps of capacitive elements from a vertical position to a horizontal position).

In one or more embodiments, capacitive elements may be arranged in a horizontal orientation in a low equivalent series inductance (ESL) and/or low profile design, having the end caps on a same side (e.g. both end caps below) the HV+ and HV- electrode plates. In one or more embodiments, a design for capacitive elements may take advantage of production processes in basic construction of the capacitive elements and enable a better (or improved) thermal conductivity of the capacitive elements between the required end caps of the capacitive elements (e.g., the one or more HV- end caps and the one or more HV+ end caps) and/or terminations than across the body of the capacitive elements. For example, the thermal conductivity may be increased by approximately six times (e.g., ~6x ratio).

In one or more embodiments, capacitive cells may use improved thermal interfaces while maintaining the required HV insulation. In one or more embodiments, the stack-up of various layers may be used (or configured to be used) to provide required protection and improved thermal transfer through the bobbin axis (e.g., zinc end cap and terminal connections) to improve thermal performance.

One or more embodiments may include capacitive elements having improved (e.g., ~6x ratio) thermal conductivity between end caps (as compared to through the wound polypropylene film body of capacitive elements) and may provide an improved thermal interface between the end caps of the capacitive elements and the cooling surfaces. In one or more embodiments, plastic walls are intended for HV insulation and the epoxy within the capacitive cell is intended for environmental sealing and physical attachment. In one or more embodiments, because thermoplastics and epoxy have relatively poor thermal conductivity, the walls of the plastic and epoxy fill are intentionally as thin as possible to permit improved thermal transfer while providing the required HV insulation, environmental protection, and mechanical stability.

In one or more embodiments, a primary advantage of the capacitive cell is being able to transfer heat intentionally through the required and most thermally conductive axis of the capacitive element. In one or more embodiments, the thin wall HV insulation of the capacitive cell allows for higher conductivity materials to be used as part of the thermal interface to the capacitive cell (e.g., aluminum, thermally conductive adhesive/components, etc.) as required for thermal performance.

In one or more embodiments, the HV insulation and internal environmental sealing of the capacitive cell provides the required protection to allow for pre-qualification of the capacitive cell sub-components to reduce risk, cost, tooling, and testing on new inverter designs. One or more embodiments may include a design that intentionally uses (or that may be configured to intentionally use) the shape of the required electrical connection terminals that are attached to the arc sprayed zinc end caps of each capacitive element to redistribute and transfer heat to reduce hot spots within the capacitive elements. In one or more embodiments, the shape of the electrical connection terminals may be designed to redistribute and transfer heat from the capacitive elements through the bobbin axis for heat transfer (e.g., zinc end cap and terminal connection) to improve thermal performance.

One or more embodiments may include capacitive elements designed to improve (e.g., ~6x ratio) thermal conductivity between end caps (e.g., as compared to the wound polypropylene film body of capacitive elements), which may provide paths for distribution of heat in the capacitive element through the thermal interface (e.g., between the end caps of the capacitive elements) and the cooling surfaces. In one or more embodiments, a primary advantage of this design is using the shape of the required capacitor electrical connection terminals to intentionally redistribute heat within the center of the capacitive element (e.g., from AC) to reduce hot spots in the MPP film to improve capacitor reliability and also eliminate (or reduce) the need for oversizing of components to protect capacitors from thermal overload. In one or more embodiments, the shape of the electrical connection terminals may be used (or may be configured to be used) to transfer heat from internal hot spots intentionally through the required and most thermally conductive axis of the capacitive element (e.g., ~6x ratio between the surfaces of the zinc are sprayed end caps).

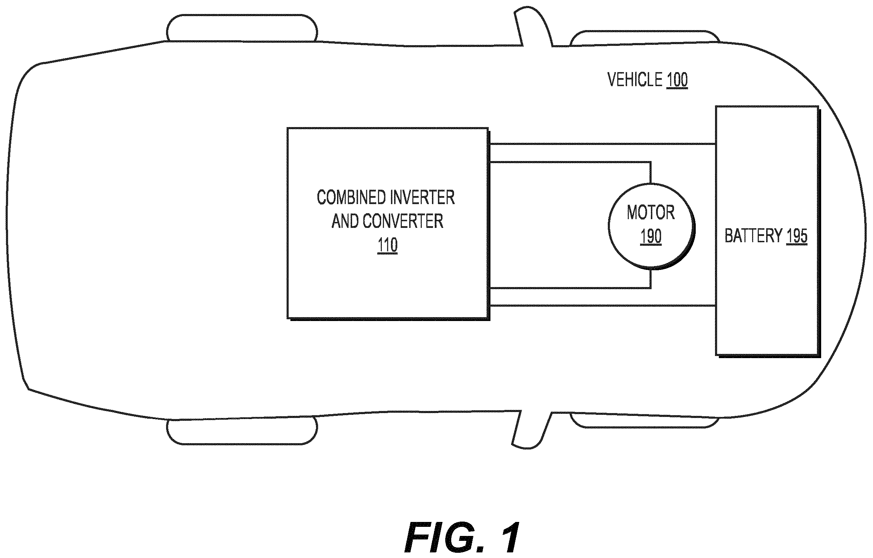

FIG. 1 depicts an exemplary system infrastructure for a vehicle including a combined inverter and converter, according to one or more embodiments. Alternatively, the inverter may be an inverter without a converter. In the context of this disclosure, the inverter without a converter, or the combined inverter and converter, may be referred to as an inverter. This disclosure provides an inverter as an example embodiment, but the disclosure is not limited to an inverter, and the description herein may be applied to any power converter or other electrical system that includes a capacitor. As depicted in FIG. 1, electric vehicle 100 may include an inverter 110, a motor 190, and a battery 195. The inverter 110 may include components to receive electrical power from an external source and output electrical power to charge the battery 195 of electric vehicle 100. The inverter 110 may convert DC power from the battery 195 in electric vehicle 100 to AC power, to drive (e.g. rotate) the motor 190 of the electric vehicle 100, for example, but the embodiments are not limited thereto. The inverter 110 may be bidirectional, and may convert DC power to AC power, or convert AC power to DC power, such as during regenerative braking, for example. The inverter 110 may be a three-phase inverter, a single-phase inverter, or a multi-phase inverter.

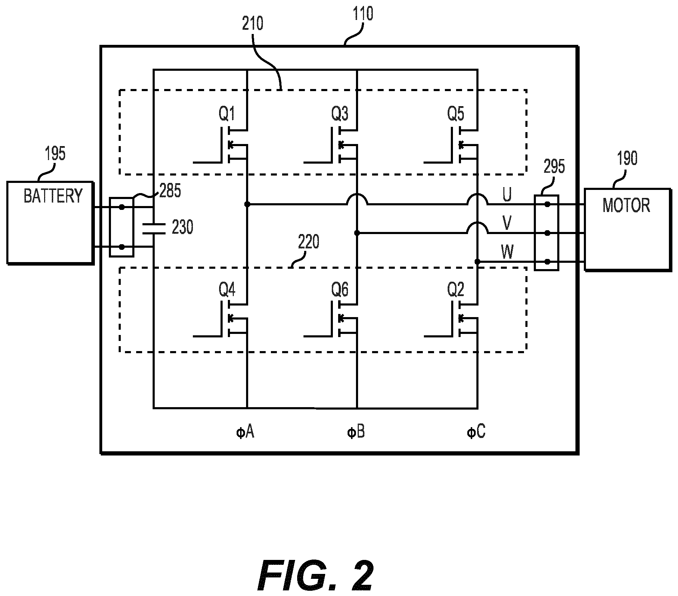

FIG. 2 depicts an electrical power schematic of a three phase inverter module, according to one or more embodiments. As depicted in FIGS. 1 and 2, the inverter 110 may be connected to the battery 195 and the motor 190. Battery 195 may be any power supply, and motor 190 may be any load. The inverter 110 may include first three-phase switch group 210, and second three-phase switch group 220. A first phase U may correlate with ΦA including switches Q1 and Q4, a second phase V may correlate with ΦB including switches Q3 and Q6, and a third phase W may correlate with ΦC including switches Q5 and Q2, as illustrated in FIG. 2. The first three-phase switch group 210 may include first phase switch Q1, second phase switch Q3, and third phase switch Q5. The second three-phase switch group 220 may include first phase switch Q4, second phase switch Q6, and third phase switch Q2. The switches Q1-Q6 may be metal-oxide-semiconductor field-effect transistors (MOSFET), for example, but are not limited thereto.

The first three-phase switch group 210 and second three-phase switch group 220 may be driven by a PWM signal generated by one or more controllers to convert DC power delivered via input terminal set 285 at capacitor 230 to three phase AC power at outputs U, V, and W via output terminal set 295 to the motor 190. Additionally, although FIGS. 1 and 2 illustrate a three-phase inverter, the disclosure is not limited thereto, and may include single phase or multi-phase inverters.

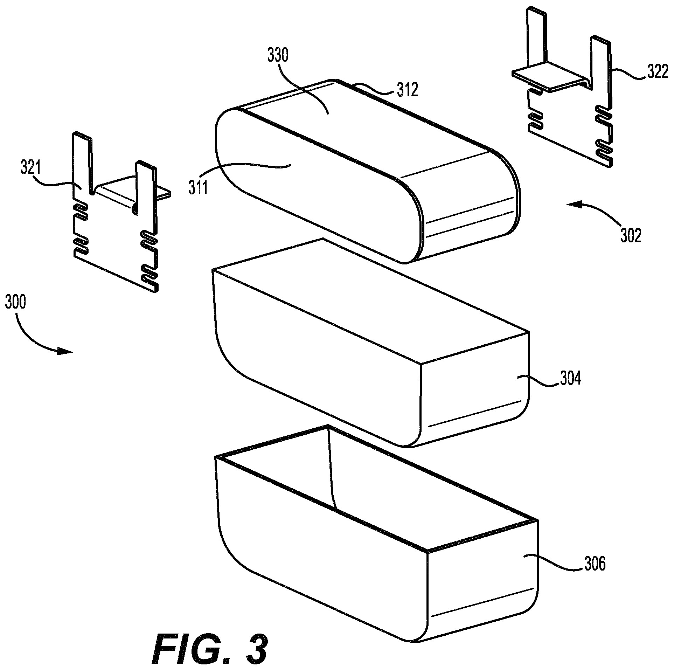

FIG. 3 depicts an exploded view of an exemplary capacitor 300, according to one or more embodiments. The capacitor 300 may be a component (e.g., capacitor 230) of the inverter 110 described in FIG. 1 and FIG. 2. The capacitor 300 may include a capacitive element 302, a first connection plate 321, a second connection plate 322, an epoxy 304, and a liner 306. The capacitor 300 may be configured to smooth voltage fluctuations and noise in the DC input received by an inverter (e.g., the inverter 110 depicted in FIG. 1). The capacitor 300 may be configured to temporarily store and release energy, filter ripple/high frequency noise, and maintain voltage levels as the inverter 110 supplies power.

The capacitor 300 may include a capacitive element 302. The capacitive element 302 may include wound metalized polypropylene film 330, a first cap 311 at a first end of wound metalized polypropylene film 330, and a second cap 312 on a second end, opposite to the first end) of wound metalized polypropylene film 330. The first cap 311 and second cap 312 may be arc-sprayed zinc applied to the wound metalized polypropylene film 330.

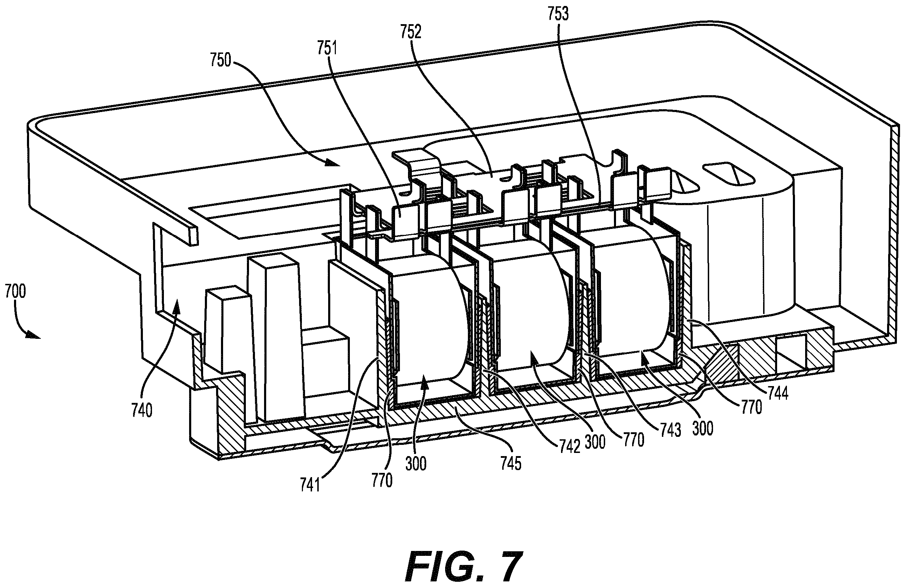

The capacitor 300 may include a first connection plate 321 and a second connection plate 322. The first connection plate 321 and second connection plate 322 may both be electrical conductors, such as a copper material, for example. In some examples, the first connection plate 321 and second connection plate 322 may be made entirely of copper. The first connection plate 321 and second connection plate 322 may both be configured to transfer heat to an external surface of the capacitor 300 and to electrically connect the capacitor 300 to one or more busbars (see FIG. 7). The first connection plate 321 may provide a High Voltage positive ("HV+") connection to a first DC busbar (e.g., an HV+ electrode plate). The second connection plate 322 may provide a High Voltage negative ("HV-") connection to a second DC busbar (e.g., an HV- electrode plate). The first connection plate 321 may couple to the first cap 311. The second connection plate 322 may couple to the second cap 312.

**The** capacitor 300 may include an epoxy 304 configured to surround the capacitive element 302. **The** epoxy 304 may be a thermal adhesive configured to protect the capacitive element 302. **The** epoxy 304 may be contained within a liner 306. **The** liner 306 may be plastic and may be configured to house the capacitive element 302 and epoxy 304. **The** liner 306 may be a thin wall that extends around the capacitive element 302. **The** liner 306 may have a thickness from approximately 0.5 mm to approximately 1.5 mm, for example.

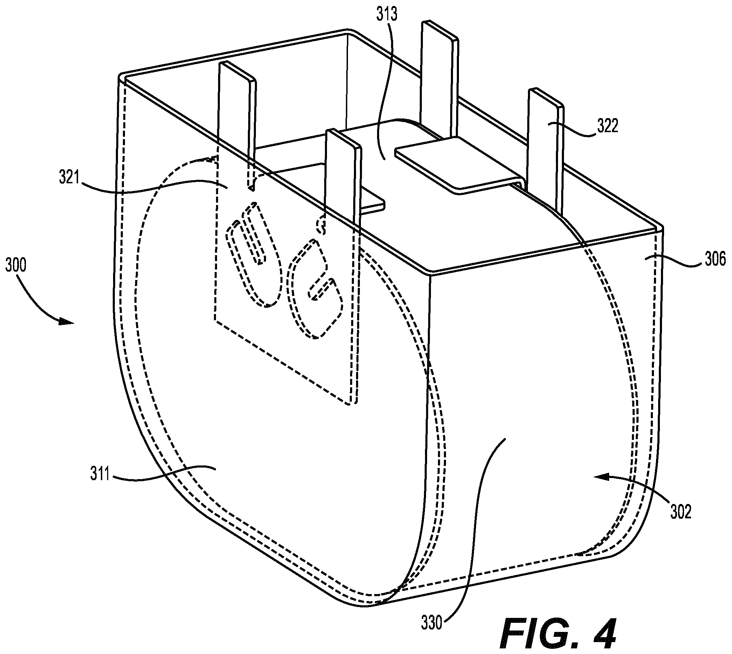

FIG. 4 depicts an exemplary capacitor (e.g., capacitor 300) without epoxy, according to one or more embodiments. FIG. 4 depicts the capacitor 300 prior to addition of the epoxy 304 in order to display details of the connections of the first connection plate 321 to the first cap 311 of the capacitive element 302. The connections of the second connection plate 322 to the second cap 312 may be similar thereto. The first connection plate 321 and the second connection plate 322 may be aligned on the capacitive element 302 and may extend in a substantially similar direction away from the capacitive element 302. FIG. 4 depicts the liner 306 as transparent to depict the arrangement of the capacitive element 302 within the liner 306.

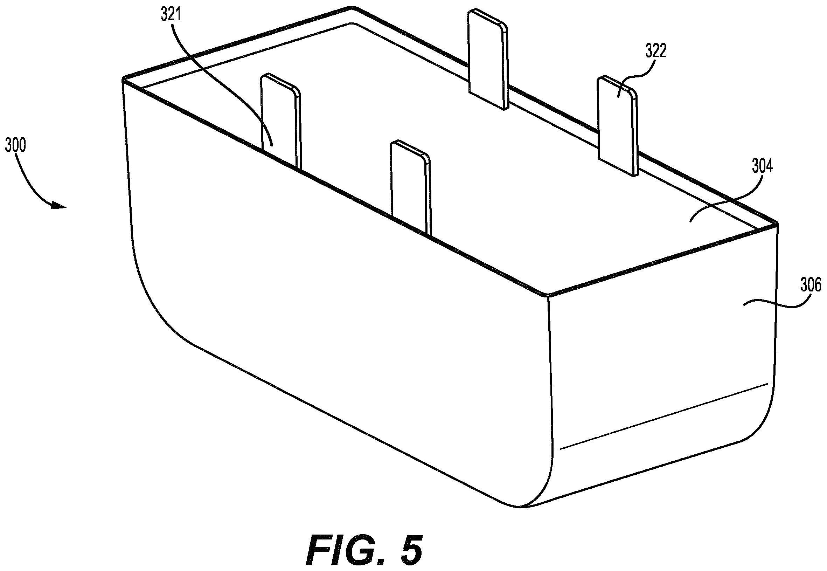

FIG. 5 depicts an exemplary capacitor (e.g., capacitor 300), according to one or more embodiments. Epoxy 304 may be added in the liner 306 on capacitive element 302. As depicted in FIG. 5, the first connection plate 321 may extend outwardly from the epoxy 304 as a tab (e.g., two tabs). Further, the second connection plate 322 may extend outwardly from the epoxy 304 as a tab (e.g., two tabs). The tabs of the first connection plate 321 and the second connection plate 322 may be respectively coupled to busbars.

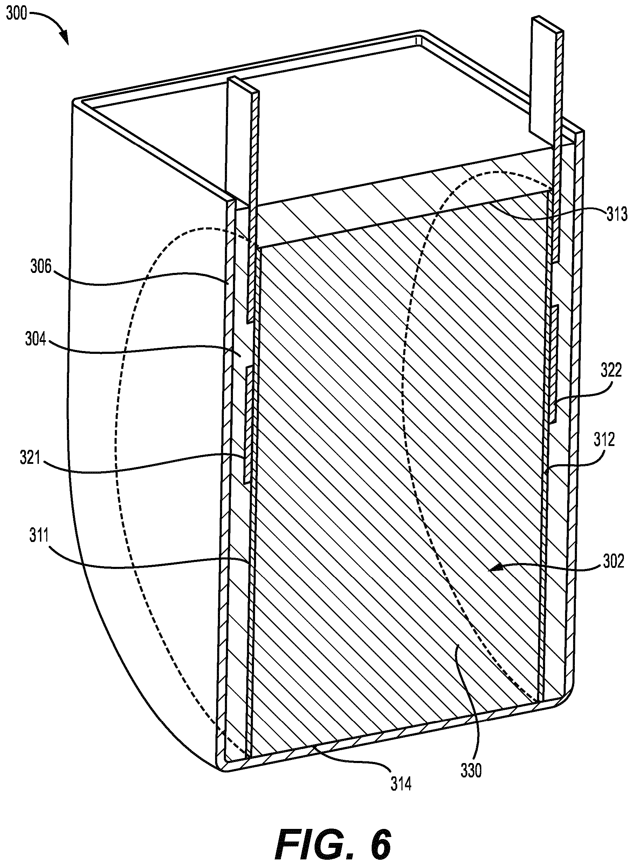

FIG. 6 depicts a cross section view of an exemplary capacitor (e.g., capacitor 300), according to one or more embodiments. FIG. 6 depicts a cross section view of the capacitor 300 between the tabs of the first connection plate 321 and the second connection plate 322 depicted in FIG. 5. The wound metalized polypropylene film 330 may be a central component of the capacitor 300. The wound metalized polypropylene film 330 may include aluminum patterns within the film. The patterns may be fuses of metallic films that act as electrodes of the capacitor 300. The patterns and thickness of the wound metalized polypropylene film 330 may determine the capacitance, voltage rating, and performance of the capacitor 300.

The first connection plate 321 and second connection plate 322 may act as electrical terminals or electrodes for the capacitor 300. The first connection plate 321 and the second connection plate 322 may be shaped to transfer heat from the respective first cap 311 and second cap 312 to an exterior surface. For example, a surface area of the first connection plate 321 and the second connection plate 322 may be oversized for the respective currents. The capacitor 300 may include an epoxy 304 in liner 306 to cover the capacitive element 302, first connection plate 321, and second connection plate 322.

FIG. 7 depicts a cross section of an inverter 700, according to one or more embodiments. The inverter 700 may correspond to inverter 110, for example. The inverter 700 may include a capacitor 300 (e.g., one or more capacitors, e.g., three capacitors) and a chassis 740. Similarly to FIG. 4, FIG. 7 depicts capacitor 300 prior to addition of the epoxy 304 in order to display the internal components and connections of the capacitor 300.

The chassis 740 may include an aluminum alloy, copper, or other suitable material that is thermally conductive. The chassis 740 may be cast aluminum, for example. The chassis 740 may act as a heat sink for a capacitor 300. The chassis 740 may include one or more walls (e.g., four walls, e.g., six walls), that extend from a floor 745 of the chassis 740. For example, a first wall 741, a second wall 742, a third wall 743, and a fourth wall 744 may extend from the floor 745 of the chassis 740. Each of the first wall 741, the second wall 742, the third wall 743, and the fourth wall 744 may include a surface (e.g., one surface, e.g., two surfaces) configured to receive heat from a respective capacitor 300. The one or more walls (e.g., the first wall 741, the second wall 742, the third wall 743, and the fourth wall 744) may be parallel to one another in a stacked formation along the floor 745 of the chassis 740. The one or more walls may have a height of approximately 2 cm and may have a thickness of approximately 2 mm, for example. The one or more walls may have a height that is a portion of a height of the respective capacitor received (e.g., capacitor 300). For example, the first wall 741 and fourth wall 744 may extend to a height that is higher than the second wall 742 and the third wall 743. In some examples, the one or more walls may decrease in width (thickness) as the wall extends away from the floor 745 of the chassis 740. The one or more walls may extend a length that approximates a length of the respective capacitor 300.

The walls of the chassis (e.g., the first wall 741, the second wall 742, the third wall 743, and the fourth wall 744) may be configured to receive a capacitor 300. For example, the first wall 741 and second wall 742 may form a pocket that may receive a capacitor 300. A thermal interface material (TIM) 770 may be located between the capacitor 300 and the respective first wall 741, second wall 742, and floor 745 of the chassis. The TIM 770 may include epoxy, silicon, or other elastomer products, for example. The TIM 770 may be provided as a dielectric pad, heat spreader, thermal compound, thermal gel (e.g., dispensable gel), thermal tape, phase change material, gap pad, thermal grease, or alternative thermal material, for example. The TIM 770 may be configured to transfer heat from the capacitor 300 to the chassis 740.

The inverter 700 may include a planar busbar 750. The planar busbar 750 may include a first DC busbar 751 that overlaps a second DC busbar 752 with an insulation layer 753 between the first DC busbar 751 and the second DC busbar 752. The insulation layer 753 may be a high voltage insulator such as porcelain (ceramic), glass, silicon rubber, epoxy resin, or a polymer. The first DC busbar 751 may be a HV+ bus bar electrode plate. The first DC busbar 751 may include copper, aluminum, brass, silver, tungsten, nickel-plated copper, a copper-alloy composite, conductive polymer, or graphite, for example. The second DC busbar 752 may be a HV- bus bar electrode plate. The second DC busbar 752 may include copper, aluminum, brass, silver, tungsten, nickel-plated copper, a copper-alloy composite, conductive polymer, or graphite, for example. The first DC busbar 751 and second DC busbar 752 may include a copper material, for example. The first DC busbar 751 and second DC busbar 752 may be aligned in a stacked position and located on a single side of a capacitor 300. The planar busbar 750 may be coupled to a capacitor 300 (e.g., one or more capacitors, e.g., three capacitors). The planar busbar 750 may be configured to distribute electrical power in inverter 700.

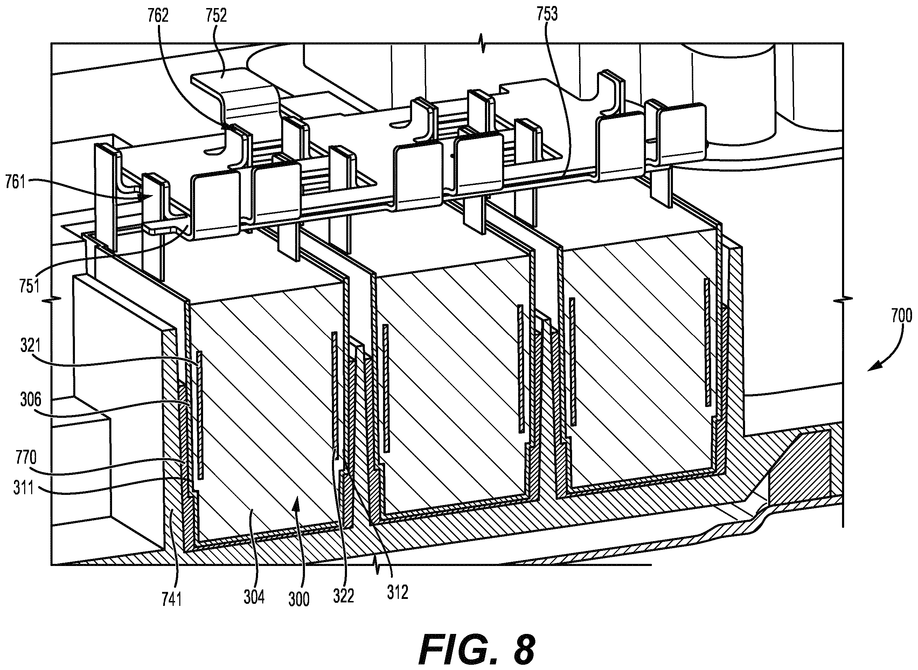

FIG. 8 depicts a detailed cross section of an inverter 700, according to one or more embodiments. The first connection plate 321 of the capacitor 300 may extend outwards as a tab (e.g., one tab, e.g., two tabs) and couple at a connection point 761 (e.g., one connection point, e.g., two connection points) to the first DC busbar 751. This connection point 761 may form an HV+ connection between the capacitor 300 and the planar busbar 750. The second connection plate 322 of the capacitor 300 may extend outwards as a tab (e.g., one tab, e.g., two tabs) and couple at a connection point 762 (e.g., one connection point, e.g., two connection points) to the second DC busbar 752. This connection point 762 may form an HV-connection between the capacitor 300 and the planar busbar 750. The first DC busbar 751 may include a connection point 761 (e.g., one connection points, e.g., two connection points), for each capacitor 300 coupled to the first DC busbar 751. The second DC busbar 752 may include a connection point 762 (e.g., one connection point, e.g., two connection points), for each capacitor 300 coupled to the second DC busbar 752. The connection point 761 and connection point 762 may electrically connect the capacitor 300 with the planar busbar 750.

Capacitor 300 may be on a same side of the first DC busbar 751 and the second DC busbar 752. Respective end caps (e.g., first cap 311 and the second cap 312) may extend in a directions substantially perpendicular to a longitudinal direction of the planar busbar 750. The first cap 311 and second cap 312 may extend in directions opposite to one another. The second cap 312 may be at an opposite end of the capacitor 300 from the first cap 311.

FIG. 9 depicts side views and a front view of a capacitive element and a busbar, according to one or more embodiments. View 900 depicts a cross section of the wound metalized polypropylene film 330, the first cap 311, the second cap 312, and the respective connection to the first connection plate 321 and second connection plate 322. View 900 depicts how the first connection plate 321 may extend outwards towards first DC busbar 751. The first connection plate 321 may extend through an opening in the second DC busbar 752 and couple at a connection point 761 to the first DC busbar 751. The second connection plate 322 may extend and couple to the second DC busbar 752 at a connection point 762. The second connection plate 322 may extend through an opening in the first DC busbar 751. Wound metalized polypropylene film 330 may be wound around centerline axis 910.

View 901 and view 902 depict respective side views of the HV connections between the respective connection plates (e.g., first connection plate 321 and second connection plate 322) and respective busbar plates (e.g., first DC busbar 751 and second DC busbar 752). Views 901 and view 902 depict views 90 degrees and 270 degrees relative to the view 900 when rotating the capacitive element along the centerline axis 910.

The view 901 depicts the HV+ connection at the connection point 761 between the first connection plate 321 and the first DC busbar 751. In some examples, the first connection plate 321 may include two separate tabs that both connect to the first DC busbar 751. The view 902 depicts the HV- connection at the connection point 762 between the second connection plate 322 and the second DC busbar 752. In some examples, the second connection plate 322 may include two separate tabs that both connect to the first DC busbar 751.

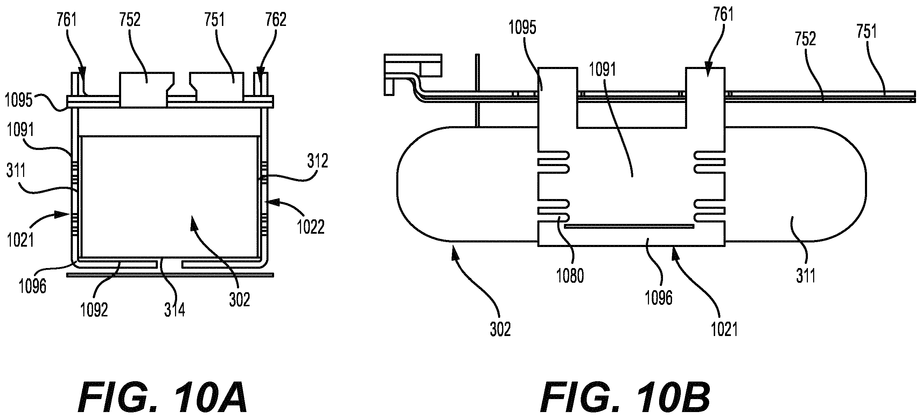

FIG. 10A depicts a front view of a capacitor assembly with an L-shaped connection plate 1021, according to one or more embodiments. For example, the L-shaped connection plate 1021 may be an exemplary first connection plate 321 described above. The capacitive element 302 may include an L-shaped connection plate 1022 that is an exemplary second connection plate 322.

The L-shaped connection plate 1021 may include a first portion 1091 that includes a first end 1095 and a second end 1096 opposite to the first end 1095. The first portion 1091 may receive heat from the first cap 311 and extend along an entire length of the first cap 311. The L-shaped connection plate 1021 may include a second portion 1092 that extends perpendicular from the first portion 1091 at the second end 1096. The second portion 1092 may receive heat from the bottom surface 314 of the capacitive element 302. The capacitive element 302 may be between the planar busbar (e.g., e.g., first DC busbar 751 and second DC busbar 752) and the second portion 1092.

FIG. 10B depicts a side view of a capacitor assembly with an L-shaped connection plate 1021, according to one or more embodiments. FIG. 10B depicts how the L-shaped connection plate 1021 may be coupled to first cap 311 at a connection point 1080 (e.g., one connection point on each cap, e.g., one or more connection points on each cap for reliability, e.g., four connection points on each cap to distribute heat across a surface of the cap through the connection plate rather than a surface of the cap). The connection point 1080 may be a solder, a weld, a mechanical fastener (e.g., a bolt, clamp, or lug), or press fitted between the L-shaped connection plate 1021 and first cap 311.

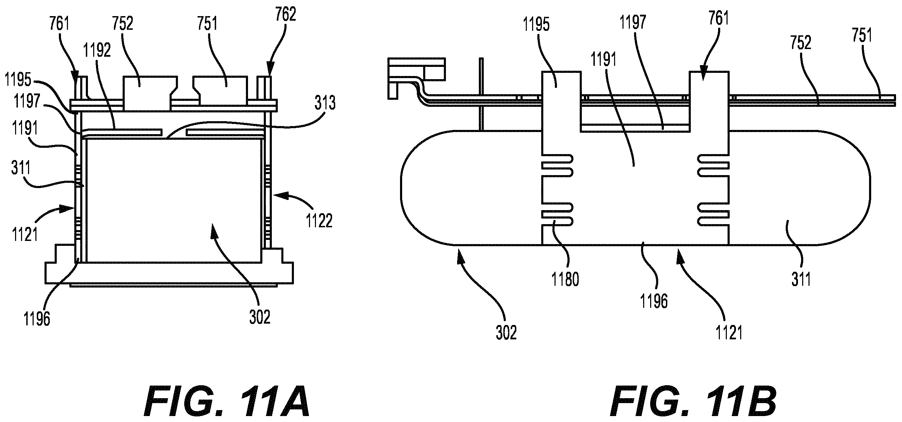

FIG. 11A depicts a front view of a capacitor assembly with a T-shaped connection plate 1121, according to one or more embodiments. For example, the T-shaped connection plate 1121 may be an exemplary first connection plate 321 described above. The capacitive element 302 may include a T-shaped connection plate 1122 that is an exemplary second connection plate 322.

The T-shaped connection plate 1121 may include a first portion 1191 that includes a first end 1195 and a second end 1196 opposite to the first end 1195. The first portion 1191 may receive heat from the first cap 311 and extend along an entire length of the first cap 311. The T-shaped connection plate 1121 may include a second portion 1192 that extends perpendicular from the first portion 1191 at a location 1197 of the first portion 1191 between the first end 1195 and second end 1196. The second portion 1192 may receive heat from the top surface 313 of the capacitive element 302. The second portion 1092 may be between the planar busbar (e.g., first DC busbar 751 and second DC busbar 752) and the capacitive element 302.

FIG. 11B depicts a side view of a capacitor assembly with a T-shaped connection plate 1121, according to one or more embodiments. FIG. 11B depicts how the T-shaped connection plate 1121 may be coupled to first cap 311 at a connection point 1180 (e.g., one connection point, e.g., one or more connection points, e.g., four connection points). The connection point 1180 may be a solder, a weld, a mechanical fastener (e.g., a bolt, clamp, or lug), or press fitted between the T-shaped connection plate 1121 and first cap 311.

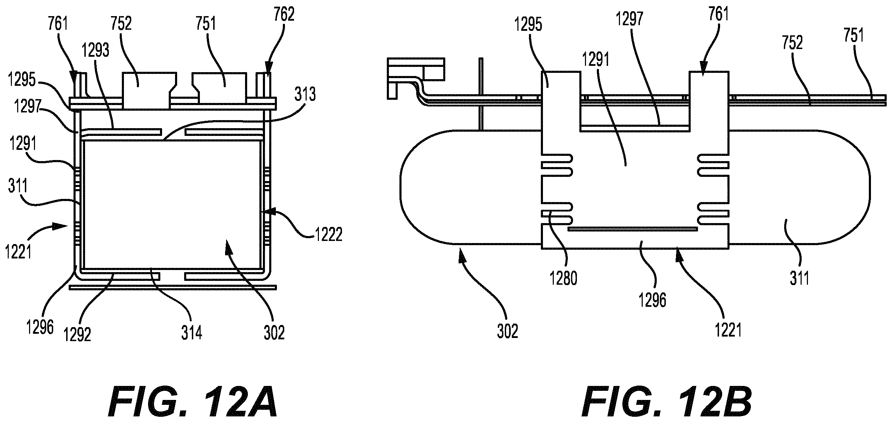

FIG. 12A depicts a front view of a capacitor assembly with a C-shaped connection plate 1221, according to one or more embodiments. For example, the C-shaped connection plate 1221 may be an exemplary first connection plate 321 described above. The capacitive element 302 may include a C-shaped connection plate 1222 that is an exemplary second connection plate 322.

The C-shaped connection plate 1221 may include a first portion 1291 that includes a first end 1295 and a second end 1296 opposite to the first end 1295. The first portion 1291 may receive heat from the first cap 311 and extend along an entire length of the first cap 311. The C-shaped connection plate 1221 may include a second portion 1292 that extends perpendicular from the first portion 1291 at the second end 1296. The second portion 1292 may receive heat from the bottom surface 314 of the capacitive element 302. The C-shaped connection plate 1221 may include a third portion 1293 that extends perpendicular from the first portion 1291 at a location 1297 of the first portion 1291 between the first end 1295 and second end 1296. The third portion 1293 may receive heat from the top surface 313 of the capacitive element 302. The capacitive element 302 may be between the second portion 1292 and the third portion 1293.

FIG. 12B depicts a side view of a capacitor assembly with a C-shaped connection plate 1221, according to one or more embodiments. FIG. 12B depicts how the C-shaped connection plate 1221 may be coupled to first cap 311 at a connection point 1280 (e.g., one connection point, e.g., one or more connection points, e.g., four connection points). The connection point 1280 may be a solder, a weld, a mechanical fastener (e.g., a bolt, clamp, or lug), or press fitted (e.g., mechanically stamped) between the C-shaped connection plate 1221 and first cap 311.

In one or more embodiments, capacitive elements may be arranged in a horizontal orientation in a low equivalent series inductance (ESL) and/or low profile design, having the end caps on a same side (e.g. both end caps below) the HV+ and HV- electrode plates. In one or more embodiments, a design for capacitive elements may take advantage of production processes in basic construction of the capacitive elements and enable a better (or improved) thermal conductivity of the capacitive elements between the required end caps of the capacitive elements (e.g., the one or more HV- end caps and the one or more HV+ end caps) and/or terminations than across the body of the capacitive elements. For example, the thermal conductivity may be increased by approximately six times (e.g., ~6x ratio).

In one or more embodiments, capacitive cells may use improved thermal interfaces while maintaining the required HV insulation. In one or more embodiments, the stack-up of various layers may be used (or configured to be used) to provide required protection and improved thermal transfer through the bobbin axis (e.g., Zinc end cap and terminal connections) to improve thermal performance.

One or more embodiments may include capacitive elements having improved (e.g., ~6x ratio) thermal conductivity between end caps (as compared to through the wound polypropylene film body of capacitive elements) may provide an improved thermal interface between the end caps of the capacitive elements and the cooling surfaces. In one or more embodiments, plastic walls are intended for HV insulation and the epoxy within the capacitive cell is intended for environmental sealing and physical attachment. In one or more embodiments, because thermoplastics and epoxy have relatively poor thermal conductivity, the walls of the plastic and epoxy fill are intentionally as thin as possible to permit improved thermal transfer while providing the required HV insulation, environmental protection, and mechanical stability.

In one or more embodiments, a primary advantage of the capacitive cell is being able to transfer heat intentionally through the required and most thermally conductive axis of the capacitive element. In one or more embodiments, the thin wall HV insulation of the capacitive cell allows for higher conductivity materials to be used as part of the thermal interface to the capacitive cell (e.g., aluminum, thermally conductive adhesive/components, etc.) as required for thermal performance. **In** one or more embodiments, the HV insulation and internal environmental sealing of the capacitive cell provides the required protection to allow for pre-qualification of the capacitive cell sub-components to reduce risk, cost, tooling, and testing on new inverter designs.

One or more embodiments may include a design that intentionally uses (or that may be configured to intentionally use) the shape of the required electrical connection terminals that are attached to the arc sprayed Zinc end caps of each capacitive element to redistribute and transfer heat to reduce hot spots within the capacitive elements. In one or more embodiments, the shape of the electrical connection terminals is intentionally designed to redistribute and transfer heat from the capacitive elements through the bobbin axis for heat transfer (e.g., Zinc end cap and terminal connection) to improve thermal performance.

One or more embodiments may include capacitive elements designed to improve (e.g., ~6x ratio) thermal conductivity between end caps (e.g., as compared to the wound polypropylene film body of capacitive elements), which may provide paths for distribution of heat in the capacitive element through the thermal interface (e.g., between the end caps of the capacitive elements) and the cooling surfaces. In one or more embodiments, a primary advantage of this design is using the shape of the required capacitor electrical connection terminals to intentionally redistribute heat within the center of the capacitive element (e.g., from AC) to reduce hot spots in the MPP film to improve capacitor reliability and also eliminate (or reduce) the need for oversizing of components to protect capacitors from thermal overload. In one or more embodiments, the shape of the electrical connection terminals may be used (or may be configured to be used) to transfer heat from internal hot spots intentionally through the required and most thermally conductive axis of the capacitive element (e.g., ~6x ratio between the surfaces of the Zinc are sprayed end caps).

Other embodiments of the disclosure will be apparent to those skilled in the art from consideration of the specification and practice of the invention disclosed herein. It is intended that the specification and examples be considered as exemplary only, with a true scope and spirit of the invention being indicated by the following claims.

## Claims

1. A system comprising an inverter to convert direct current (DC) power from a battery to alternating current (AC) power to drive a motor, wherein the inverter includes:
a capacitor assembly, the capacitor assembly including:
a planar busbar including a first DC busbar and a second DC busbar;
a capacitor on a same side of the first DC busbar and the second DC busbar, the capacitor including a first end cap extending in a direction substantially perpendicular to a longitudinal direction of the planar busbar; and
a first connection plate shaped to transfer heat from the first end cap of the capacitor and the first connection plate to a first external surface.

2. The system of claim 1, wherein the first connection plate extends beyond electrical connections to the first end cap.

3. The system of any one of claims 1 to 2, wherein the first connection plate includes:
a first portion at the first end cap; and
a second portion extending substantially perpendicular from the first portion, wherein the capacitor is between the planar busbar and the second portion of the first connection plate.

4. The system of any one of claims 1 to 2, wherein the first connection plate includes:
a first portion at the first end cap; and
a second portion extending substantially perpendicular from the first portion, wherein the second portion of the first connection plate is between the capacitor and the planar busbar;
and/or wherein the first connection plate further includes:
a first portion at the first end cap;
a second portion extending substantially perpendicular from the first portion; and
a third portion extending substantially perpendicular from the first portion, wherein the capacitor is between the second portion and the third portion.

5. The system of any one of claims 1 to 4, wherein the first connection plate includes copper.

6. The system of any one of claims 1 to 5, wherein the capacitor further includes:
a second end cap extending in the direction substantially perpendicular to the longitudinal direction of the planar busbar, the second end cap on an end of the capacitor that is opposite to that of the first end cap;
and preferably, wherein the system further includes:
a second connection plate provided at the second end cap to connect the capacitor to the second DC busbar, wherein the second connection plate is shaped to transfer heat from the second end cap of the capacitor and the second connection plate to a second external surface.

7. The system of any one of claims 1 to 6, further comprising:
the battery configured to supply the DC power to the inverter; and
the motor configured to receive the AC power from the inverter to drive the motor,
wherein the system is provided as a vehicle.

8. The system of any one of claims 1 to 7, wherein the first connection plate includes four connection points that couple the first connection plate to the first end cap; and/or
wherein the first connection plate includes a first tab and a second tab, wherein the first tab and the second tab both connect to the first DC busbar.

9. A capacitor assembly comprising:
a capacitor including a wound metalized polypropylene film including a central axis, a first end cap on a first end of the wound metalized polypropylene film, and a second end cap on a second end, opposite to the first end, of the wound metalized polypropylene film;
a first connection plate on the first end cap, wherein the first connection plate is oversized for a rated current to thereby transfer heat away from the capacitor; and
a second connection plate on the second end cap, wherein the second connection plate is oversized for the rated current to thereby transfer heat away from the capacitor.

10. The capacitor assembly of claim 9, wherein the first connection plate includes:
a first portion at the first end cap; and
a second portion extending substantially perpendicular from the first portion and contacting the capacitor.

11. The capacitor assembly of any one of claims 9 to 10, wherein the capacitor includes a first surface and a second surface opposite to the first surface, wherein the first surface of the capacitor connects the first end cap to the second end cap, and the second surface of the capacitor connects the first end cap to the second end cap.

12. The capacitor assembly of claim 11,
wherein the first connection plate includes:
a first portion at the first end cap; and
a second portion extending substantially perpendicular from the first portion, the second portion contacting the first surface or the second surface of the capacitor; or
wherein the first connection plate includes:
a first portion at the first end cap;
a second portion extending substantially perpendicular from the first portion and contacting the first surface of the capacitor; and
a third portion extending substantially perpendicular from the first portion and contacting the second surface of the capacitor.

13. A capacitor assembly for a power converter chassis pocket, the capacitor assembly comprising:
a planar busbar including a first DC busbar and a second DC busbar;
a capacitor on a same side of the first DC busbar and the second DC busbar, the capacitor including:
a metalized polypropylene film wound around a central axis extending in a direction substantially parallel with a longitudinal direction of the planar busbar,
a first end cap on a first end of the metalized polypropylene film, and
a second end cap on a second end of the metalized polypropylene film opposite from the first end;
a first connection plate provided at the first end cap to connect the capacitor to the first DC busbar; and
a second connection plate provided at the second end cap to connect the capacitor to the second DC busbar,
wherein the first connection plate and the second connection plate are shaped to transfer heat from the first end cap and the second end cap to the power converter chassis pocket.

14. The capacitor assembly of claim 13, wherein the first connection plate extends along an entire length of the first end cap; and/or
wherein the first connection plate is coupled to the first end cap by mechanical stamping; and/or
wherein a portion of the first connection plate is located between the capacitor and the planar busbar.
